# EUROPEAN PATENT APPLICATION

(11) **EP 2 048 205 A1**
(43) Date of publication of application: **15.04.2009**
(21) Application number: 07745203.5
(22) Date of filing: 13.06.2007
(51) Int. Cl.: C09D 17/00, B22F 9/24, H05K 1/09, H05K 3/12

(54) **DISPERSION CONATINING METAL FINE PARTICLES, PROCESS FOR PRODUCTION OF THE DISPERSION, AND ARTICLES HAVING METAL FILMS**

(30) Priority: 28.07.2006 JP 2006206454
(71) Applicant: Asahi Glass Company, Limited, Chiyoda-ku Tokyo 100-8405 (JP)
(72) Inventor: HIRAKOSO, Hideyuki, Tokyo 100-8405 (JP); ABE, Keisuke, Tokyo 100-8405 (JP); SANADA, Yasuhiro, Tokyo 100-8405 (JP)
(74) Representative: Müller-Boré & Partner Patentanwälte
(86) International application number: PCT/JP2007/061936
(87) International publication number: WO 2008/013002

(57) **Abstract**

To provide a dispersion which is excellent in oxidation resistance and dispersion stability, and which contains metal fine particles capable of forming a metal film excellent in conductivity; a process for producing it; and an article having a metal film excellent in conductivity.

A process for producing a dispersion of metal fine particles, which comprises heating a dispersion of metal hydride fine particles, comprising a dispersion medium, metal hydride fine particles dispersed in the medium and having an average particle size of at most 50 nm, and an organic compound with from 4 to 1000 carbon atoms, having an amino group, in an inert atmosphere at a temperature of from 60 to 350°C; a dispersion containing metal fine particles, obtained by such a process; and an article having a metal film formed by applying the dispersion containing metal fine particles on a substrate and firing it.

## Description

### TECHNICAL FIELD

The present invention relates to a dispersion containing metal fine particles, a process for producing it, and an article having a metal film made of the dispersion containing metal fine particles.

### BACKGROUND ART

In recent years, a method of forming a metal film has been proposed, wherein a dispersion of metal fine particles having fine particles of metal e.g. copper dispersed in a dispersion medium is applied in a desired pattern form, and the coated film is fired to sinter the metal fine particles to one another.
(1) A method wherein a dispersion containing metal fine particles is applied by an inkjet printing method, followed by sintering to form and repair a circuit pattern such as a printed wiring to provide interlayer wiring inside of a semiconductor package, or to bond a printed wiring board and an electronic component (Patent Document 1).
(2) A method wherein, instead of soldering, a dispersion containing metal fine particles is applied, followed by sintering to have metals bonded to one another (Patent Document 2).
(3) A method wherein a dispersion containing metal fine particles is applied, followed by sintering to form a plating film in the field of electronic materials (Patent Document 3).

The methods (1) to (3) are methods of utilizing a surface melt phenomenon of metal fine particles. The surface melt phenomenon of metal fine particles is known to take place by abnormal lattice vibration of atoms at the surface of particles, and in such a phenomenon, the temperature for surface melt decreases as the particle size of the metal fine particles gets small, and as the proportion of the surface atoms gets high. In a case of copper, the melting point of a bulk body is 1,083°C, but in a case of fine particles having a particle size of about 10 nm, it is known that surface melt takes place from about 150°C. The phenomenon is dependent on the particle size of the metal fine particles, whereby unless the fine particles themselves are completely bonded to each other, it takes place even with an association state, as long as individual metal fine particles have a prescribed particle size.

However, the metal fine particles are easily oxidized, and particularly, when the particle size becomes 100 nm or smaller, the surface area becomes large, whereby the influence of surface oxidation becomes remarkable, and when a metal film is formed, the surface of metal fine particles becomes oxidized. Therefore, it has a problem such that conductivity can hardly be obtained.
Patent Document 1: JP-A-2002-324966
Patent Document 2: JP-A-2002-126869
Patent Document 3: JP-A-2002-334618

### DISCLOSURE OF THE INVENTION

### OBJECTS TO BE ACCOMPLISHED BY THE INVENTION

The present invention provides a dispersion of metal fine particles, which can form a metal film excellent in oxidation resistance and dispersion stability and excellent in conductivity (in the present specification, also simply referred to as a metal fine particle dispersion), a process for producing it, and an article having a metal film excellent in conductivity.

### MEANS TO ACCOMPLISH THE OBJECTS

The process for producing a metal fine particle dispersion of the present invention comprises heating a dispersion of metal hydride fine particle (in the present specification, also simply referred to as a metal hydride fine particle dispersion), comprising a dispersion medium, metal hydride fine particles dispersed in the medium and having an average particle size of at most 50 nm, and an organic compound with from 4 to 1,000 carbon atoms, having an amino group, in an inert atmosphere at a temperature of from 60 to 350°C to convert the above metal hydride fine particles to metal fine particles.

In the present invention, the above metal hydride fine particle dispersion is preferably obtained by a process having the following steps (a) to (e):
(a) a step of dissolving a water-soluble metal compound in water to prepare an aqueous solution containing metal ions,
(b) a step of adding an acid to the aqueous solution to adjust the pH to be at most 3,
(c) a step of adding an organic compound having an amino group and an insoluble organic solvent to the aqueous solution adjusted to have a pH of at most 3, followed by stirring to obtain a suspension,
(d) a step of reducing the metal ions by adding a reducing agent to the suspension while stirring the suspension to form metal hydride particles having an average particle size of at most 50 nm, and
(e) a step of separating the suspension into an aqueous layer and an oil layer, followed by recovering the oil layer as a dispersion of metal hydride fine particles.

The above metal is preferably copper or nickel.

The above inert atmosphere contains at most 1,000 ppm of oxygen.

The above metal fine particle dispersion preferably contains metal fine particles having an average particle size of at most 50 nm.

The above metal fine particle dispersion preferably contains from 5 to 60 mass% of metal fine particles in 100 mass% of the metal fine particle dispersion.

The above metal hydride fine particle dispersion preferably contains from 1 to 50 parts by mass of an organic compound with from 4 to 1,000 carbon atoms, having an amino group, per 100 parts by mass of the metal hydride fine particles.

The above metal hydride fine particle dispersion preferably contains from 1 to 40 mass% of metal hydride fine particles in 100 mass% of the metal hydride fine particle dispersion.

The metal fine particle dispersion of the present invention is one obtained by the process for producing a metal fine particle dispersion of the present invention.

The article of the present invention is one comprising a substrate and a metal film formed thereon by applying the metal fine particle dispersion obtained by the process for producing a metal fine particle dispersion of the present invention and firing it.

### EFFECTS OF THE INVENTION

The metal fine particle dispersion of the present invention is excellent in oxidation resistance and dispersion stability. Further, by the metal fine particle dispersion of the present invention, it is possible to form a metal film excellent in conductivity.

According to the process for producing a metal fine particle dispersion of the present invention, it is possible to produce a metal fine particle dispersion which can form a metal film excellent in oxidation resistance and dispersion stability, and excellent in conductivity.

The article of the present invention has a metal film excellent in conductivity.

### BEST MODE FOR CARRYING OUT THE INVENTION

### PROCESS FOR PRODUCING METAL FINE PARTICLE DISPERSION

The process for producing the metal fine particle dispersion of the present invention is a process which comprises heating a metal hydride fine particle dispersion, comprising a dispersion medium, metal hydride fine particles dispersed in the medium and having an average particle size of at most 50 nm, and an organic compound (hereinafter referred to as a protectant) with from 4 to 1,000 carbon atoms, having an amino group, in an inert atmosphere at a temperature of from 60 to 350°C.

The heating is carried out after the metal hydride fine particle dispersion is introduced in a reactor, and inside of the reactor is replaced with an inert atmosphere.

The gas to form an inert atmosphere may, for example, be nitrogen, argon or helium. The concentration of oxygen in such a gas is preferably at most 1,000 ppm, more preferably at most 200 ppm. When the concentration of oxygen in the gas is at most 1,000 ppm, the oxidation of metal fine particles can be suppressed.

The heating temperature is preferably from 60 to 350°C, more preferably from 80 to 200°C. When the heating temperature is at least 60°C, decomposition of the metal hydride fine particles can be efficiently carried out. When the heating temperature is at most 350°C, agglomeration of the metal fine particles can be suppressed without having a protectant detached from the metal fine particles.

The heating time can suitably be decided depending on the heating temperature, and it is usually preferably from 5 to 180 minutes, more preferably from 30 to 60 minutes. When the heating time is at least 5 minutes, it is possible to sufficiently heat the entire dispersion. When the heating time is at most 180 minutes, it is possible to shorten the treating time.

### DISPERSION MEDIUM

The dispersion medium of the dispersion is preferably a non-water soluble organic solvent (hereinafter referred to as an organic solvent) from the viewpoint that when it is mixed with an aqueous solution which will be mentioned later, dissolution of water to the dispersion medium can be suppressed, and the change in characteristics of the dispersion medium is small. The term "non-water soluble" means that solubility in 100 g of water at room temperature (20°C) is at most 0.5 g.

The organic solvent is preferably one having less polarity. The organic solvent having less polarity has good compatibility with a protectant. The organic solvent is preferably one which does not undergo thermal decomposition by heating when producing the metal fine particle dispersion or when forming the metal film.

The boiling point of the organic solvent is preferably from 60 to 350°C, more preferably from 80 to 200°C. When the boiling point of the organic solvent is at least 60°C, decomposition of the metal hydride fine particles sufficiently proceeds. When the boiling point of the organic solvent is at most 350°C, the viscosity of the organic solvent does not become too high, and the dispersion can be uniformly heated.

The organic solvent may be at least one member selected from the group consisting of octane (insoluble in water), decane (insoluble in water), dodecane (insoluble in water), tetradecane (insoluble in water), decene (insoluble in water), dodecene (insoluble in water), tetradecene (insoluble in water), dipentene (solubility in 100 g of water: 0.001 g (20°C)), terpineol (solubility in 100 g of water: 0.5 g (20°C)), toluene (insoluble in water), xylene (insoluble in water) and mesitylene (insoluble in water).

### PROTECTANT

The protectant suppresses the agglomeration of the metal hydride fine particles and metal fine particles and suppresses the oxidation of the metal hydride fine particles and metal fine particles.

The protectant is an organic compound with from 4 to 1,000 carbon atoms, having an amino group. When the number of carbon atoms is at least 4, the effect of steric hindrance by a carbon chain is brought about, and the dispersion stability will be improved. When the number of carbon atoms is at most 1,000, the molecular chain is not too long, and entanglement of the protectant itself can be suppressed, whereby the dispersion stability will not be deteriorated. The number of carbon atoms is preferably from 4 to 200, more preferably from 4 to 20, particularly preferably from 4 to 18.

The protectant may be saturated or unsaturated. The protectant is preferably linear.

The amino group in the protectant may be present at any position in the molecule, and it is preferably present at the terminal from the viewpoint of thermal stability, proper steam pressure and good handling efficiency.

The protectant is preferably one having at least 2 amino groups since such a protectant has a stronger coordinate bond with the metal hydride fine particles or the metal fine particles.

The protectant is preferably one which does not detach from the metal hydride fine particles or the metal fine particles, in a temperature range of an usual storage environment or a heating temperature range.

The organic compound with from 4 to 20 carbon atoms, having an amino group may, for example, be dodecylamine, octylamine, aminodecane, stearylamine, oleylamine, benzylamine, stearylamide or oleylamide.

The protectant is preferably a polymer dispersant with from 4 to 1,000 carbon atoms, having an amino group from the viewpoint of improving the dispersion stability.

As such polymer dispersants, the following commercial products may be mentioned.

Products manufactured by BYK-Chemie include Anti-Terra-U (a salt of a long-chain polyaminoamide and an acid polymer), Anti-Terra-204 (a polycarboxylate of polyaminoamide), Disperbyk-101 (a salt of a long-chain polyaminoamide and a polar acid ester), Disperbyk-106 (a polymer salt having an acidic group), Disperbyk-108 (a hydroxyl group-containing carboxylate), Disperbyk-109 (an alkylol aminoamide), Disperbyk-112 (an acrylic copolymer having an affinity to a pigment), Disperbyk-116 (an acrylic copolymer having an affinity to a pigment), Disperbyk-130 (an unsaturated polycarboxylic polyaminoamide), Disperbyk-140 (an alkylammonium salt of an acid polymer), Disperbyk-142 (phosphate having an affinity to a pigment), Disperbyk-145 (phosphate of a copolymer having an affinity to a pigment), Disperbyk-161 (a block copolymer having an affinity to a pigment), Disperbyk-162 (a block copolymer having an affinity to a pigment), Disperbyk-164 (a block copolymer having an affinity to a pigment), Disperbyk-166 (a block copolymer having an affinity to a pigment), Disperbyk-167 (a block copolymer having an affinity to a pigment), Disperbyk-168 (a block copolymer having an affinity to a pigment), Disperbyk-2000 (a modified acrylic block copolymer), Disperbyk-2001 (a modified acrylic block copolymer), Disperbyk-2020 (a modified acrylic block copolymer), Disperbyk-2050 (an acrylic copolymer having an affinity to a pigment), Disperbyk-2070 (an acrylic copolymer having an affinity to a pigment) and Disperbyk-2150 (a block copolymer having an affinity to a pigment);

Products manufactured by Kawaken Fine Chemicals Co., Ltd. include Hinoakuto KF1500 (a single anchor type cationic surfactant) and Hinoakuto KF1700 (a single anchor type cationic surfactant);

Products manufactured by Ajinomoto Fine-Techno Co., Inc. include AJISPER PB821 (a basic polymer dispersing agent), AJISPER PB822 (a basic polymer dispersing agent) and AJISPER PB711 (a basic polymer dispersing agent);

Products manufactured by Kusumoto Chemicals, Ltd. include DISPARLON 1860 (a salt of a long-chain polyaminoamide and a polymer polyester acid), DISPARLON KS873N (an amine salt of polyester), DISPARLON DA703-50 (an amideamine salt of a polymer polyester acid) and DISPARLON DA7400 (an amideamine salt of a polymer polyester acid); and

Products manufactured by Ciba Specialty Chemicals K.K. include EFKA-4401 (a modified polyacrylic polymer dispersing agent), EFKA-5044 (unsaturated polyester polyamide), EFKA-5207 (unsaturated carboxylic acid containing a hydroxyl group), EFKA-6225 (aliphatic acid-modified polyester), EFKA-4330 (an acrylic block copolymer type polymer dispersing agent), EFKA-4047 (a modified polyurethane type polymer dispersing agent) and EFKA-4060 (a modified polyurethane type polymer dispersing agent).

Such protectants may be used alone or in combination as a mixture of two or more of them.

The amount of the protectant may be suitably selected depending on the particular application of the dispersion, and it is usually preferably from 1 to 50 parts by mass, more preferably from 2 to 20 parts by mass, per 100 parts by mass of the metal hydride fine particles. When the amount of the protectant is at least 1 part by mass, agglomeration of the metal hydride fine particles and metal fine particles can sufficiently be suppressed, and oxidation of the metal hydride fine particles and metal fine particles can sufficiently be suppressed. When the amount of the protectant is at most 50 parts by mass, it is possible to form a metal film having good conductivity.

### METAL HYDRIDE FINE PARTICLES

The metal hydride fine particles are fine particles of a metal hydride wherein metal atoms and hydrogen atoms are bonded. The metal hydride fine particles have a characteristic such that they decompose into metal and hydrogen at a temperature of at least 60°C. Thus, they become metal fine particles when heated under an inert atmosphere.

The metal hydride fine particles may, for example, be copper hydride fine particles, nickel hydride fine particle or palladium hydride fine particles, and from the viewpoint that a metal film excellent in conductivity can be formed, copper hydride fine particles or nickel hydride fine particles are preferred, and copper hydride fine particles are more preferred. The metal hydride fine particles are preferably produced by a moisture-reduction method which will be described later.

The metal hydride fine particles are preferably coated with the protectant, in the dispersion, with a view to suppressing agglomeration and oxidation of the metal hydride fine particles.

The average particle size of the metal hydride fine particles is at most 50 nm, preferably from 5 to 30 nm. When the average particle size of the metal hydride fine particles is at most 50 nm, the dispersion becomes excellent in dispersing stability. The average particle size of the metal hydride fine particles is a value obtained in such a manner that particle sizes of 100 metal hydride fine particles randomly extracted were measured by using transmission electron microscope (TEM) or scanning electron microscope (SEM), and the measured particle sizes are averaged.

The concentration of the metal hydride fine particles is preferably from 1 to 40 mass%, more preferably from 5 to 20 mass%, in 100 mass% of the dispersion. When the concentration of the metal hydride fine particles is at least 1 mass%, the productivity is good. When the concentration of the metal hydride fine particles is at most 40 mass%, the agglomeration of fine particles by heating hardly takes place.

### PRODUCTION OF METAL HYDRIDE FINE PARTICLE DISPERSION

The metal hydride fine particles can be produced by a method described in e.g. WO2004/110925.

The metal hydride fine particle dispersion is, specifically, produced via the following steps:
(a) a step of dissolving a water-soluble metal compound in water to prepare an aqueous solution containing metal ions,
(b) a step of adding an acid to the aqueous solution to adjust the pH to be at most 3,
(c) a step of adding an organic solvent and a protectant to the aqueous solution, followed by stirring to obtain a suspension,
(d) a step of reducing the metal ions by adding a reducing agent to the suspension while stirring the suspension to form metal hydride fine particles (a wet-reduction method), and
(e) a step of separating the suspension into an aqueous layer and an oil layer, followed by recovering the oil layer as a metal hydride fine particle dispersion.

### STEP (a):

The water-soluble metal compound may, for example, be a sulfate, nitrate, acetate, chloride, bromide or iodide of a metal.

The concentration of the water-soluble metal compound is preferably from 0.1 to 30 mass% in 100 mass% of the aqueous solution. When the concentration of the water-soluble copper compound is at least 0.1 mass%, the amount of water can be suppressed, and the productivity of the metal hydride fine particles improves. When the concentration of the water-soluble metal compound is at most 30 mass%, the dispersion stability of the metal hydride fine particles becomes good.

### STEP (b):

The acid may, for example, be citric acid, maleic acid, malonic acid, acetic acid, propionic acid, sulfuric acid, nitric acid or hydrochloric acid, and citric acid, maleic acid or malonic acid is preferred from the viewpoint that it forms a stable complex with a metal ion thereby to prevent adsorption of hydration water to the metal ion.

By adjusting the aqueous solution to have a pH of at most 3, the metal ions in the aqueous solution can easily be reduced, and metal hydride fine particles can easily be formed. That is, metal fine particles are rarely formed. The pH of the aqueous solution is preferably adjusted to be from 1 to 2 from the viewpoint that the metal hydride fine particles can be formed in a short period of time.

### STEP (c):

To the aqueous solution obtained in the step (b), an organic solvent and a protectant are added. By mixing an aqueous layer made of the aqueous solution containing the metal ions with an oil layer made of the organic solvent containing the protectant, a suspension is obtained.

### STEP (d):

By adding a reducing agent to the suspension obtained in the step (c), the metal ions in the aqueous layer are reduced by the reducing agent under an acidic environment, and the metal hydride fine particles gradually increase. The metal hydride fine particles will have their surfaces immediately coated with the protectant dissolved in the oil layer and will be taken into the oil layer and stabilized. That is, on the surfaces of the synthesized metal hydride fine particles, the protectant is coordinated so that the metal hydride fine particles are coated by the protectant, whereby agglomeration of the metal hydride fine particles themselves can be suppressed.

The reducing agent is preferably a metal hydride since it has a large reducing effect. The metal hydride may, for example, be lithium aluminum hydride, lithium borohydride, sodium borohydride, lithium hydride, potassium hydride or calcium hydride, and it is preferably lithium aluminum hydride, lithium borohydride or sodium borohydride.

The amount of the reducing agent to be added is preferably from 1.5 to 10 times by equivalent to the metal ions. When the amount of the reducing agent to be added is at least 1.5 times by equivalent to the metal ions, the reducing action will be sufficient. When the amount of the reducing agent to be added is at most 10 times by equivalent to the metal ions, the dispersion stability of the metal hydride fine particles will be good.

The temperature when the reducing agent is added to the suspension is preferably from 5 to 60°C, particularly preferably from 10 to 40°C. When the temperature is at most 60°C, decomposition of the metal hydride fine particles can be suppressed.

### STEP (e):

After the metal hydride fine particles are synthesized, the suspension is left to stand, whereby it will be separated into an aqueous layer and an oil layer. By recovering the oil layer, it is possible to obtain a dispersion wherein the metal hydride fine particles are dispersed in the organic solvent. To the dispersion, an organic solvent can be additionally added as the case requires.

### METAL FINE PARTICLES DISPERSION

The metal fine particle dispersion of the present invention is a metal fine particle dispersion obtained by the process for producing the metal fine particle dispersion of the present invention.

The metal fine particles may, for example, be metal copper fine particles, metal nickel fine particles or metal palladium fine particles, and it is preferably metal copper fine particles or metal nickel fine particles, more preferably metal copper fine particles, from the viewpoint that a metal film excellent in conductivity can be formed.

The metal fine particles are preferably coated with the protectant in the dispersion so that agglomeration and oxidation of the metal fine particles can be suppressed.

The average particle size of the metal fine particles is preferably at most 50 nm, more preferably from 5 to 30 nm. When the average particle size of the metal fine particles is at most 50 nm, a fine wiring pattern can be formed. Further, since the surface melting temperature decreases, surface fusion tends to readily take place. Further, a dense metal film can be formed, and the conductivity will be improved. The average particle size of the metal fine particles is a value obtained in such a manner that particle sizes of 100 metal fine particles randomly extracted were measured by using transmission electron microscope (TEM) or scanning electron microscope (SEM), and the measured particle sizes were averaged.

The concentration of the metal fine particles is preferably from 5 to 60 mass%, more preferably from 10 to 50 mass%, in 100 mass% of the metal fine particle dispersion. When the concentration of the metal fine particles is at least 5 mass%, a metal film having a sufficient thickness can be formed, whereby the conductivity will be improved. When the concentration of the metal fine particles is at most 60 mass%, the ink properties such as the viscosity, surface tension, etc. of the metal fine particle dispersion become good, whereby the handling efficiency will be improved.

The amount of the protectant in the metal fine particle dispersion is usually preferably from 1 to 300 parts by mass, more preferably from 1 to 100 parts by mass, per 100 parts by mass of the metal fine particles. When the amount of the protectant is at least 1 part by mass, agglomeration of the metal fine particles can sufficiently be suppressed, and oxidation of the metal fine particles can sufficiently be suppressed. When the amount of the protectant is at most 300 parts by mass, a metal film having good conductivity can be formed.

The metal fine particle dispersion may contain a known additive, organic binder, etc., as the case requires.

### ARTICLE CONTAINING METAL FILM

The article of the present invention is one comprising a substrate and a metal film formed thereon by applying the metal fine particle dispersion and firing it.

The article may, for example, be a printed wiring board, a semiconductor package or a display panel.

### SUBSTRATE

The substrate may, for example, be a glass substrate, a plastic substrate or a fiber-reinforced composite material. As the substrate, a substrate containing polyimide is preferred from the viewpoint of excellent adhesion with the metal film.

The substrate containing polyimide may, for example, be a polyimide film, a laminate film or a laminate board having a polyimide layer as the outermost layer, a glass fiber-reinforced composite material wherein a matrix resin is polyimide, or a silica composite film wherein a matrix resin is polyimide.

The polyimide may be a reaction product of an aromatic tetracarboxylic dianhydride with an aromatic diamine. The aromatic tetracarboxylic dianhydride may, for example, be 3,4,3',4'-biphenyl tetracarboxylic dianhydride or pyromellitic dianhydride. The aromatic diamine may, for example, be paraphenylene diamine or 4,4'-diaminodiphenyl ether.

The polyimide can contain a known additive such as an inorganic filler, an inorganic phosphor or an organic phosphor.

### METAL FILM

The metal film may be a continued film covering the whole surface of the substrate, or a film having desired patterns.

The volume resistance of the metal film is preferably at most 100 µΩcm, more preferably at most 50 µΩcm.

The thickness of the metal film is preferably from 0.5 to 10 µm, more preferably from 0.5 to 5 µm.

### PRODUCTION OF ARTICLE

The article is, for example, produced via the following steps:
(I) a step of applying the metal fine particle dispersion of the present invention on the surface of the substrate to form a coated film; and
(II) a step of forming a metal film by firing the coated film.

### STEP (I):

In the step, the metal fine particle dispersion of the present invention may be applied to cover the whole surface of the substrate, or the metal fine particle dispersion of the present invention may be applied in desired patterns on the surface of the substrate.

The coating method may be a known method such as an inkjet printing method; a dispense method, a screen printing method, a roll coating method, an air knife coating method, a blade coating method, a bar coating method, a gravure coating method, a die coating method, a spray coating method or a slide coating, and an inkjet printing method is preferred, since it is thereby easy to apply the dispersing in desired patterns.

The inkjet printing method is a method using an inkjet printer. An ink discharging hole of an inkjet printer is usually from 1 to 50 µm.

While a droplet of ink flies in a space after discharged from the ink discharging hole, its diameter changes and after it adheres on the surface of an electrical insulation layer 12, it spreads on the surface of the substrate. The diameter of ink droplet immediately after discharged is almost the same as the diameter of the ink discharging hole, and after the droplet is adhered on the substrate, the diameter of the ink droplet spreads until from 5 to 100 µm. Therefore, the metal fine particles in the metal fine particle dispersion may be agglomerated as long as an ink viscosity, etc. are not influenced. The agglomerated size is preferably not more than 2 µm.

### STEP (II):

The substrate having a coated film formed thereon is placed in a firing furnace, and under an inert gas atmosphere such as nitrogen, the inner temperature of the firing furnace is raised to a firing temperature at a rate of 10°C/min. Such a temperature is kept for a prescribed time (hereinafter referred to as a retention time) to carry out firing. By firing, fusion of the metal fine particles proceeds to form a metal film.

The firing temperature is preferably at least 150°C, more preferably from 200 to 400°C, particularly preferably from 250 to 350°C. When the firing temperature is at least 150°C, the fusion of the metal fine particles proceeds, and the volume resistance of the metal film becomes good.

The retention time is preferably from 30 to 240 minutes, more preferably from 30 to 120 minutes. When the retention time is at least 30 minutes, the fusion of the metal fine particles proceeds, and the volume resistance of the metal film becomes good.

According to the above-described process for producing the metal fine particle dispersion of the present invention, the metal fine particles are synthesized by decomposing the metal hydride fine particles in the presence of the protectant, whereby the metal fine particles in the dispersion are hardly oxidized or agglomerated. Therefore, the metal fine particle dispersion thereby obtained is excellent in oxidation resistance and dispersion stability.

Further, by using the metal fine particle dispersion of the present invention, it is possible to form a metal film excellent in conductivity. The reason is considered as follows.

A nitrogen atom of an amino group in the protectant has a noncovalent electron pair, whereby the nitrogen atom is more strongly coordinated to the metal fine particles, and during firing, (i) oxidation of the metal fine particles can be suppressed, and the oxidation degree of the metal film tends to be low, and (ii) the metal fine particles are free from agglomeration, and the metal fine particles fused to one another in a state of being dispersed uniformly, whereby a dense metal film can be formed.

### EXAMPLES

Now, the present invention will be described in further detail with reference to Examples, but it should be understood that the present invention is by no means restricted thereto.

Example 1 is Example of the present invention, and Examples 2 to 5 are Comparative Examples.

The concentration of a solution or a dispersion is a concentration represented by mass.

### IDENTIFICATION OF PARTICLES

Identification of copper hydride particles and metal copper fine particles was made by using an X-ray diffractometer (manufactured by Rigaku Corporation, RINT2500).

### AVERAGE PARTICLE SIZE OF FINE PARTICLES

The average particle sizes of the copper hydride fine particles and the metal copper fine particles were obtained by measuring the particle sizes of randomly extracted 100 fine particles by using a transmission electron microscope (manufactured by Hitachi, Ltd., H-9000) or a scanning electron microscope (manufactured by Hitachi, Ltd., S-800) and averaging them out.

### THICKNESS OF METAL FILM

The thickness of the metal film was measured by using a contact film thickness measuring apparatus (manufactured by Veeco, DekTak3).

### VOLUME RESISTANCE OF METAL FILM

The volume resistance of the metal film was calculated by multiplying the thickness of the metal film to a surface resistance value measured by using a 4 probe resistance meter (manufactured by Mitsubishi Petrochemical Co., Ltd., LorestaIP MCP-T250).

### EXAMPLE 1

In a glass reactor, 5 g of copper (II) chloride dihydrate was dissolved in 150 g of distilled water to obtain an aqueous solution containing copper ions. The aqueous solution had a pH of 3.4.

To the aqueous solution, 90 g of a 40% citric acid aqueous solution was added, followed by stirring for a while. The aqueous solution had a pH of 1.7.

To the aqueous solution, a solution of a mixture of 0.4 g of dodecylamine and 20 g of xylene was added, followed by intense stirring to obtain a suspension.

While the suspension was intensely stirred, 150 g of a 3% sodium boron hydride aqueous solution was slowly dropwisely added.

After the dropwise addition, the suspension was left to stand for 1 hour for separation into an aqueous layer and an oil layer, and then only the oil layer was recovered. A black dispersion having fine particles dispersed in xylene was obtained.

The fine particles in the dispersion were recovered and identified by an X-ray diffraction, whereby it was confirmed that they were copper hydride fine particles.

The average particle size of the fine particles dispersed in the dispersion was 10 nm.

The concentration of copper hydride fine particles in the dispersion was 10 mass%.

The copper hydride fine particle dispersion was introduced in a glass reactor and was heated at 80°C for 60 minutes in a nitrogen atmosphere having an oxygen concentration of 200 ppm. After heating, it was gradually cooled to room temperature in the same nitrogen atmosphere.

The fine particles in the dispersion were recovered and identified by an X-ray diffraction, whereby it was confirmed that they were copper metal fine particles.

The average particle size of fine particles dispersed in the dispersion was 10 nm.

The concentration of copper metal fine particles in the dispersion was 8 mass%.

After the copper metal fine particle dispersion was left in air for a whole day, it was applied on a polyimide substrate by using a bar coater, followed by drying, and a formed coated film was fired at 200°C for 1 hour in a nitrogen atmosphere having an oxygen concentration of 40 ppm. A glossy metal copper-colored metal film was formed.

The volume resistance of the metal film was 15 µQcm.

The metal film was identified by an X-ray diffraction, whereby it was confirmed that it was metal copper.

The adhesion of the metal film to a polyimide substrate was evaluated by an adhesion test method (JIS K5600) of a coated film. The results are shown in Table 1. Adhesion is represented by the number of cut-sections remained, out of 100 formed cut-sections, after peeling them off by an adhesive tape.

By using the protectant in Table 1 instead of dodecylamine, differences of fine particles and volume resistance when the heating temperature, heating time and firing temperature were changed, were summarized in Table 1. Further, the adhesion of the metal film with a polyimide substrate was evaluated by an adhesion test method of a coated film (JIS K5600). The results are shown in Table 1. In Table, Cu represents metal copper, and CuH represents copper hydride.

**TABLE 1**

| Protectant | Particles before heating | Heating temperature (°C) | Heating time (min) | Particles after heating | Firing temperature (°C) | Metal film | Volume resistance (µΩcm) | Adhesion |
|---|---|---|---|---|---|---|---|---|
| Dodecylamine | CuH | 80 | 60 | Cu | 200 | Cu | 15 | 100 |
| Tetradecyl-amine | CuH | 50 | 60 | Cu+CuH | 200 | Cu | 16 | 100 |
| | CuH | 50 | 180 | Cu+CuH | 200 | Cu | 14 | 100 |
| | CuH | 80 | 60 | Cu | 200 | Cu | 14 | 100 |
| | CuH | 150 | 10 | Cu | 200 | Cu | 13 | 100 |
| | CuH | 150 | 30 | Cu | 200 | Cu | 15 | 100 |
| Oleylamine | CuH | 50 | 180 | Cu+CuH | 300 | Cu | 12 | 100 |
| | CuH | 80 | 60 | Cu | 300 | Cu | 14 | 100 |
| | CuH | 150 | 30 | Cu | 300 | Cu | 13 | 100 |
| AntiTerra-U | CuH | 80 | 60 | Cu | 350 | Cu | 15 | 100 |
| DISPARLON KS873N | CuH | 150 | 30 | Cu | 350 | Cu | 12 | 100 |

### EXAMPLE 2

A fine particle dispersion was obtained in the same manner as in Example 1 except that dodecanethiol was used instead of dodecylamine.

Fine particles in the dispersion were recovered and identified by an X-ray diffraction, whereby it was confirmed that they were copper hydride fine particles before heating, and they were metal copper fine particles after heating.

The average particle sizes of copper hydride fine particles and metal copper fine particles were both 12 nm. However, in the metal copper fine particle dispersion, the metal copper fine particles were intensely agglomerated, and the agglomerates were precipitated.

After the copper metal fine particle dispersion was left in air for a whole day, it was applied on a polyimide substrate by using a bar coater, followed by drying, and a formed coated film was fired at 200°C for 1 hour in a nitrogen atmosphere having an oxygen concentration of 40 ppm. Although a metal copper-colored film was formed, it had many crackings.

The volume resistance of the film was measured, but no conductivity was confirmed.

The film was identified by an X-ray diffraction, whereby it was confirmed that the film was metal copper.

### EXAMPLE 3

A fine particle dispersion before heating was obtained in the same manner as in Example 1 except that 15 g of a 40% citric acid aqueous solution was added. Immediately after the 40% citric acid aqueous solution was added, the aqueous solution had a pH of 3.2.

Fine particles in the dispersion were recovered and identified by an X-ray diffraction, whereby it was confirmed that they were metal copper fine particles.

The average particle size of the fine particles dispersed in the dispersion was 15 nm.

The concentration of the metal copper fine particles in the dispersion was 10%.

The metal copper fine particle dispersion was introduced in a glass reactor and heated at 80°C for 60 minutes in nitrogen having an oxygen concentration of 200 ppm. After heating, it was gradually cooled to room temperature in the same nitrogen atmosphere.

The fine particles in the dispersion were recovered and identified by an X-ray diffraction, whereby it was confirmed that they were copper metal fine particles.

The average particle size of fine particles dispersed in the dispersion was 18 nm.

The concentration of copper metal fine particles in the dispersion was 8%.

After the copper metal fine particle dispersion was left in air for a whole day, it was applied on a polyimide substrate by using a bar coater, followed by drying, and a formed coated film was fired at 200°C for 1 hour in a nitrogen atmosphere having an oxygen concentration of 40 ppm. A reddish brown film was formed.

The volume resistance of the film was 10,000 µΩcm.

The film was identified by an X-ray diffraction, whereby it was confirmed that the film was a mixture of cuprous oxide and metal copper.

### EXAMPLE 4

A fine particle dispersion before heating was obtained in the same manner as in Example 1 except that a citric acid aqueous solution was not added.

The fine particles in the dispersion were recovered and identified by an X-ray diffraction, whereby it was confirmed that they were metal copper fine particles.

The average particle size of fine particles dispersed in the dispersion was 18 nm.

The concentration of metal copper fine particles in the dispersion was 10%.

The metal copper fine particle dispersion was introduced in a glass reactor and heated at 80°C for 60 minutes in nitrogen having an oxygen concentration of 200 ppm. After heating, it was gradually cooled to room temperature in the same nitrogen atmosphere.

The fine particles in the dispersion were recovered and identified by an X-ray diffraction, whereby it was confirmed that they were copper metal fine particles.

The average particle size of fine particles dispersed in the dispersion was 18 nm.

The concentration of copper metal fine particles in the dispersion was 8%.

After the copper metal fine particle dispersion was left in air for a whole day, it was applied on a polyimide substrate by using a bar coater, followed by drying, and a formed coated film was fired at 200°C for 1 hour in a nitrogen atmosphere having an oxygen concentration of 40 ppm. A reddish brown film was formed.

The volume resistance of the film was 15,000 µΩcm.

The film was identified by an X-ray diffraction, whereby it was confirmed that the film was a mixture of cuprous oxide and metal copper.

### EXAMPLE 5

A metal copper fine particle dispersion was obtained by adding 2.0 g of a commercially available metal copper fine particles (manufactured by Ishihara Sangyo Kaisha, Ltd., MD-50) to a solution of a mixture of 0.4 g of tetradecylamine and 20 g of xylene, followed by dispersing in ultrasonic waves.

The fine particles in the dispersion were recovered and identified by an X-ray diffraction, whereby it was confirmed that they were metal copper fine particles.

The average particle size of the metal copper fine particles was 50 nm. However, in the metal copper fine particle dispersion, some of the metal copper fine particles were agglomerated, whereby agglomerates were formed.

After the copper metal fine particle dispersion was left in air for a whole day, it was applied on a polyimide substrate by using a bar coater, followed by drying, and a formed coated film was fired at 200°C for 1 hour in a nitrogen atmosphere having an oxygen concentration of 40 ppm. A reddish brown film was formed.

The volume resistance of the film was 25,000 µΩcm.

The film was identified by an X-ray diffraction, whereby it was confirmed that it was a mixture of cuprous oxide and metal copper.

### INDUSTRIAL APPLICABILITY

The metal fine particle dispersion produced by the process of the present invention is useful for formation and repairing circuit patterns such as printed wirings by an inkjet printing method, interlayer wiring in a semiconductor package, adhesion between a printed wiring board and an electronic parts, etc.

The entire disclosure of Japanese Patent Application No. 2006-206454 filed on July 28, 2006 including specification, claims and summary is incorporated herein by reference in its entirety.

## Claims

1. A process for producing a dispersion of metal fine particles, which comprises heating a dispersion of metal hydride fine particles, comprising a dispersion medium, metal hydride fine particles dispersed in the medium and having an average particle size of at most 50 nm, and an organic compound with from 4 to 1000 carbon atoms, having an amino group, in an inert atmosphere at a temperature of from 60 to 350°C to convert the above metal hydride fine particles to metal fine particles.

2. The process for producing a dispersion of metal fine particles according to Claim 1, wherein the above dispersion of metal hydride fine particles is obtained by the following steps (a) to (e) :
(a) a step of dissolving a water-soluble metal compound in water to prepare an aqueous solution containing metal ions,
(b) a step of adding an acid to the aqueous solution to adjust the pH to be at most 3,
(c) a step of adding an organic compound having an amino group and an insoluble organic solvent to the aqueous solution adjusted to have a pH of at most 3, followed by stirring to obtain a suspension,
(d) a step of reducing the metal ions by adding a reducing agent to the suspension while stirring the suspension to form metal hydride particles having an average particle size of at most 50 nm, and
(e) a step of separating the suspension into an aqueous layer and an oil layer, followed by recovering the oil layer as a dispersion of metal hydride fine particles.

3. The process for producing a dispersion of metal fine particles according to Claim 1 or 2, wherein the above metal is copper or nickel.

4. The process for producing a dispersion of metal fine particles according to any one of Claims 1 to 3, wherein the above inert atmosphere contains at most 1,000 ppm of oxygen.

5. The process for producing a dispersion of metal fine particles according to any one of Claims 1 to 4, wherein the above dispersion of metal fine particles contains metal fine particles having an average particle size of at most 50 nm.

6. The process for producing a dispersion of metal fine particles according to any one of Claims 1 to 5, wherein the above dispersion of metal fine particles contains from 5 to 60 mass% of metal fine particles in 100 mass% of the dispersion of metal fine particles.

7. The process for producing a dispersion of metal fine particles according to any one of Claims 1 to 6, wherein the above dispersion of metal hydride fine particles contains from 1 to 50 parts by mass of an organic compound with from 4 to 1000 carbon atoms, having an amino group, per 100 parts by mass of the metal hydride fine particles.

8. The process for producing a dispersion of metal fine particles according to any one of Claims 1 to 7, wherein the above dispersion of metal hydride fine particles contains from 1 to 40 mass% of metal hydride fine particles in 100 mass% of the dispersion of metal hydride fine particles.

9. A dispersion of metal fine particles which is obtained by the process as defined in any one of Claims 1 to 8.

10. An article comprising a substrate and a metal film formed thereon by applying the dispersion of metal fine particles obtained by the process as defined in any one of Claims 1 to 8 and firing it.
